Europäisches Patentamt

(19) European Patent Office

Office européen des brevets

(11) Publication number: **0 085 481**

**B1**

(12) **EUROPEAN PATENT SPECIFICATION**

(45) Date of publication of patent specification: **11.09.85**

(21) Application number: **83300109.2**

(22) Date of filing: **10.01.83**

(51) Int. Cl.⁴: **G 01 R 31/06, G 01 R 31/34**

(54) **Apparatus for detecting polarity of the excitation poles of a D.C. motor.**

(30) Priority: **11.01.82 US 338596**

(43) Date of publication of application:
**10.08.83 Bulletin 83/32**

(45) Publication of the grant of the patent:
**11.09.85 Bulletin 85/37**

(84) Designated Contracting States:
**DE FR GB IT NL**

(56) References cited:
**DE-C- 741 353**
**DE-C- 764 779**
**US-A-2 599 960**
**US-A-2 644 919**

(73) Proprietor: **E.I. DU PONT DE NEMOURS AND COMPANY**
**1007 Market Street**
**Wilmington Delaware 19898 (US)**

(72) Inventor: **Phillips, Alton Eugene**
**54 Lubeck Hills RT. 1**
**Washington West Virginia 26181 (US)**

(74) Representative: **Jones, Alan John et al**
**CARPMAELS & RANSFORD 43 Bloomsbury Square**
**London, WC1A 2RA (GB)**

Courier Press, Leamington Spa, England.

## Description

### Background of the Invention

This invention relates to electric rotary machines and more particularly it relates to apparatus for detecting polarity of the excitation poles of a direct current motor.

Tests for providing positive verification of direct current (D.C.) motor reliability that include proper hookup of internal connections to determine polarity of the excitation poles of a D.C. motor often requires disassembly of the motor to make such tests. The present invention provides apparatus for making such tests without disassembly of the motor.

### Summary of the Invention

An apparatus is provided for detecting the polarity of the excitation poles of a direct current motor. The apparatus includes a source of alternating current connected to the field being checked for polarity, a cathode ray oscilloscope having vertical gain terminals and a luminescent screen and a movable voltage pickup in close proximity to a pole of the field being checked for polarity. The pickup is moved from one pole to the next around the exterior of the motor and has a pair of output leads connecting the pickup to the vertical terminals of the oscilloscope, whereby a sine wave appears on the luminescent screen and the leading portion of the sine waves leads upwardly or downwardly in alternating fashion as the pickup is moved in turn from pole to pole around the motor when the poles are properly connected to each other.

### Brief Description of the Drawings

FIG. 1 is a schematic drawing showing the apparatus of this invention connected to the interpoles of a D.C. motor.

FIG. 2 is a schematic drawing illustrating the leading portion of a sine wave alternating in direction in serially connected field windings.

FIG. 3 is a schematic drawing showing the A.C. source hooked up to check the series field of the D.C. motor.

FIG. 4 is a schematic drawing showing the A.C. source hooked up to check the shunt field of the D.C. motor.

### Detailed Description of the Preferred Embodiment

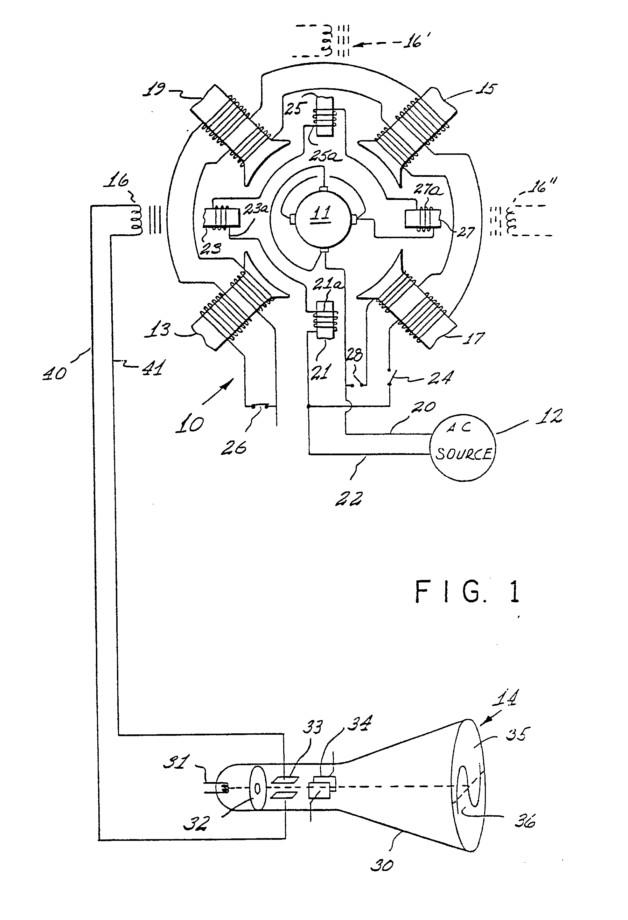

Referring to FIG. 1, the embodiment chosen for purposes of illustration includes D.C. motor 10, a variable alternating current source 12, an oscilloscope 14 and a voltage pickup device generally designated at 16.

The D.C. motor 10 illustrates an armature 11, a four pole field consisting of windings on opposed pairs of cores 13, 15 and 17, 19. Between the four main field excitation poles are positioned interpoles 21, 23, 25 and 27 with their serially connected windings 21a, 23a, 25a and 27a. Leads 20, 22 connect the serially connected interpole windings to the A.C. source 12. For purposes of convenience of illustration switch disconnects 24, 26 are shown in the shunt field winding circuit of the motor and disconnect switch 28 is positioned in the series field winding circuit of the motor. Switches 24 and 28 are shown in the open position while switch 26 is closed.

The oscilloscope 14 has as its main component a cathode ray tube 30 which has a utility in the study of electrical wave forms. The tube 30 has as its main components a cathode or a filament 31, an anode 32, which is a disc pierced by a hole and two pairs of plates 33 and 34 arranged in planes at right angles to each other. Upon heating the filament 31 and maintaining a difference of potential between it and the anode 32 an electron stream will pass through the hole in the anode and travel straight to the luminescent screen producing a luminous spot. When used as an oscilloscope to show a wave form of an alternating voltage the pair of plates designated 34 is periodically charged at a uniform rate and then suddenly discharged, each time sweeping the luminous spot across the screen 35 along the dotted line and making it return to the starting point again. The alternating voltage is applied to the other pair of plates 33 thereby producing vertical displacement of the spot; the combination of the two displacements gives a picture showing the wave shape, such as sine wave 36 on screen 35. Voltage pickup 16 is movable around the periphery of the motor and connected to the vertical input terminals of the oscilloscope through a pair of leads 40, 41 one end of the pair being connected to opposite ends of the voltage pickup coil and the other being connected to the vertical input terminals of the oscilloscope.

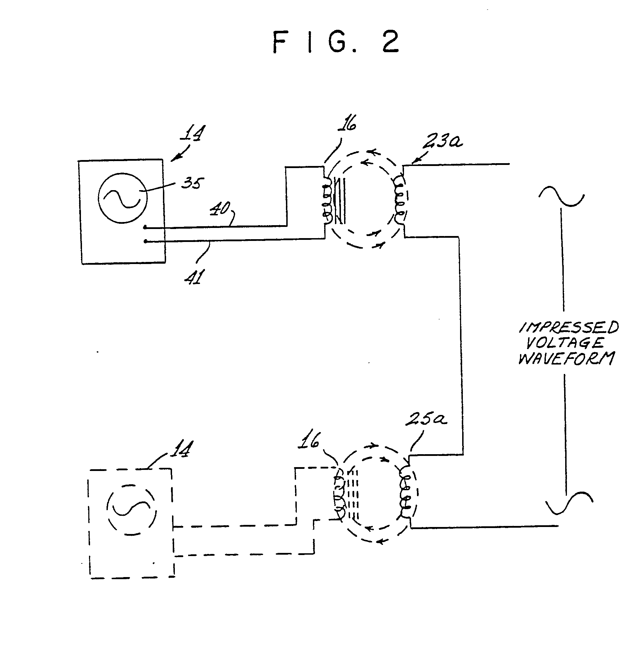

As shown in FIGS. 1 and 2, with the A.C. source connected to the interpole windings, the method of checking polarity and proper connection of the interpole windings involves placing voltage pickup 16 on the outside of motor 10 over an interpole such as 23 and observing the leading portion of the sine wave at the left side of screen; if the deflection of the leading portion of sine wave starts upwardly for interpole 23 then it must start downwardly when the pickup is placed at interpole 25 and 21 and upwardly at interpole 27 in an alternating fashion as the pickup 16 is moved around the motor to positions 16', 16'', etc. If the interpoles do not check out this way they must be connected so they will.

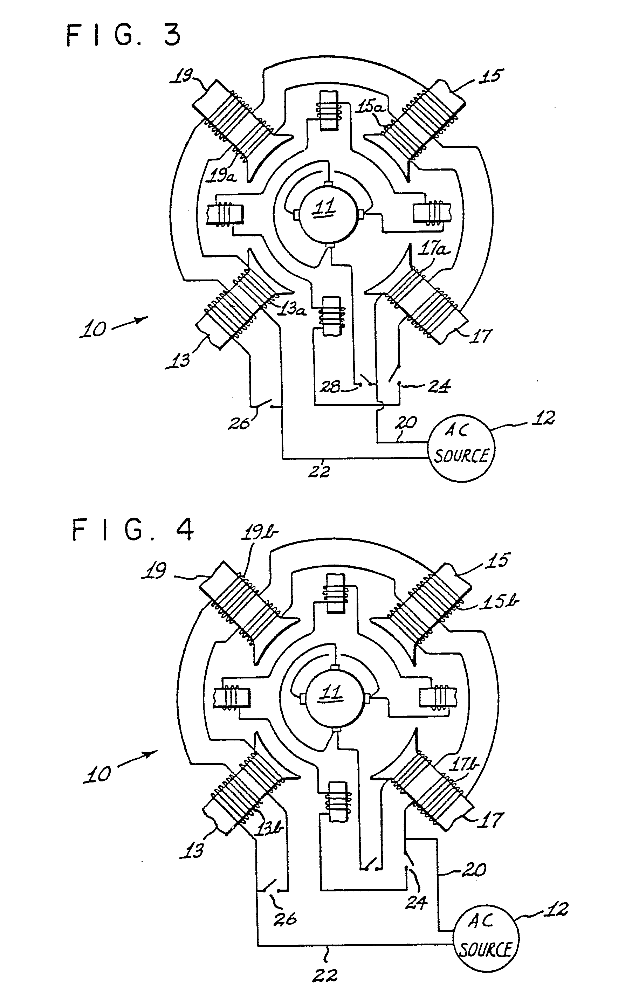

FIG. 3 shows the A.C. source 12 connected to motor 10 for checking polarity of the poles of the series fields 13, 15, and 17, 19. The leads 20, 22 are connected across windings 13a, 15a, 17a and 19a with disconnect switches 24, 26, 28 open. The procedure with voltage pickup 16 and oscilloscope 14 is repeated in a consistent manner as described above. As each pole of the series field is checked in turn the deflection of the oscilloscope screen must start in the opposite direction. If not, the series windings must be reconnected.

In a similar fashion the poles of the shunt field windings 13b, 15b, 17b and 19b are checked for proper polarity by connecting the A.C. source as shown in FIG. 4. As each pole of the shunt field is measured with voltage pickup 16 and oscilloscope 14 in a consistent manner as previously described, the leading portion of the deflection on the scope screen must start upwardly or downwardly in an alternating fashion as the pickup is moved in turn from field pole to field pole around the periphery of the motor. This relationship must be consistent with the series field; if not the shunt field winding must be reconnected.

## Claim

1. An apparatus for detecting polarity of the field excitation poles of a direct current motor including a source of alternating current connected to the field being checked for polarity, a cathode ray oscilloscope having vertical gain input terminals and a luminescent screen, and a movable voltage pickup coil in close proximity to a pole of said field being checked for polarity, characterized in that the pickup coil is movable from one of said poles to the next in turn around the exterior of the motor and has a pair of leads connected from the coil to the vertical input terminals of the oscilloscope, whereby a sine wave appears on the luminescent screen and the leading portion of said sine waves leads upwardly or downwardly in alternating fashion as the pickup is moved in turn from pole to pole around the motor when said poles are properly connected to each other.

## Patentanspruch

1. Vorrichtung zur Ermittlung der Polarität der Felderregerpole eines Gleichstrommotors, die eine Wechselstromquelle, die mit dem hinsichtlich der Polarität zu prüfenden Feld verbunden ist, einen Elektronenstrahloszillographen, der vertikale Verstärkungseingangsanschlüsse und einen Leuchtschirm hat, und eine bewegliche Spannungsabtastspule in unmittelbarer Nähe zu einem Pol des hinsichtlich der Polarität zu prüfenden Feldes enthält, dadurch gekennzeichnet, daß die Abtastspule von einem der Pole zum nächsten im Kreis um das Äußere des Motors bewegbar ist und ein Paar Leitungen hat, die ausgehend von der Spule mit den vertikalen Eingangsanschlüssen der Oszillographen bunden sind, wobei eine Sinuswelle auf dem Leuchtschirm erscheint und der vordere Teil der Sinuswelle alternierend nach oben oder unten bei der Bewegung der Abtasteinrichtung von Pol zu Pol im Kreis um den Motor zeigt, wenn die Pole richtig miteinander verbunden sind.

## Revendication

1. Appareil pour la détection de la polarité des pôles d'excitation de champ d'un moteur à courant continu comportant une source de courant alternatif reliée au champ dont la polarité est examinée, un oscilloscope à rayons cathodiques comportant des bornes d'entrée de déviation verticale et un écran luminescent, ainsi qu'un enroulement capteur de tension mobile placé à proximité immédiate d'un pôle dudit champ dont la polarité est en cours d'examen, caractérisé en ce que l'enroulement capteur (16) est mobile tour à tour de l'un desdits pôles (13, 15 et 17, 19) au suivant autour de l'extérieur du moteur (10) et comporte une paire de conducteurs (40, 41) reliant l'enroulement (16) aux bornes de déviation verticale (33) de l'oscilloscope (14), d'où s'ensuit qu'il apparaît une sinusoïde (36) sur l'écran luminescent (35) et que la portion de début de ladite sinusoïde (36) part vers le haut ou vers le bas de manière alternée lorsque l'on fait passer tour à tour le capteur (16) de pôle en pôle en le déplaçant autour du moteur (10) quand lesdits pôles (13, 15 et 17, 19) sont correctement connectés entre eux.

F I G. 1

# F I G. 2

IMPRESSED
VOLTAGE
WAVEFORM

# F I G. 3

# F I G. 4